# EUROPÄISCHE PATENTSCHRIFT

(11) **EP 1 573 917 B1**
(45) Veröffentlichungstag und Bekanntmachung des Hinweises auf die Patenterteilung: **03.05.2017**
(21) Anmeldenummer: 03769444.5
(22) Anmeldetag: 23.10.2003
(51) Int. Cl.: H03K 17/10, H03K 17/12, H03K 17/082, H02M 1/088, H02M 1/32

(54) **HALBLEITERSCHALTUNGSANORDNUNG ZUM STEUERN EINER HOHEN SPANNUNG ODER EINES STROMES GROSSER STROMST RKE**
SEMICONDUCTOR CIRCUIT ARRANGEMENT FOR CONTROLLING A HIGH VOLTAGE OR A HIGH INTENSITY CURRENT
DISPOSITIF DE COMMUTATION A SEMICONDUCTEURS DESTINE A LA COMMANDE D'UNE TENSION ELEVEE OU D'UN COURANT D'INTENSITE ELEVEE

(30) Priorität: 28.11.2002 DE 10255602
(43) Veröffentlichungstag der Anmeldung: 14.09.2005
(73) Patentinhaber: Infineon Technologies AG, 85579 Neubiberg (DE)
(72) Erfinder: BAYERER, Reinhold, 59581 Warstein (DE)
(74) Vertreter: Westphal, Mussgnug & Partner Patentanwälte mbB
(86) Internationale Anmeldenummer: PCT/EP2003/011757
(87) Internationale Veröffentlichungsnummer: WO 2004/049571

(56) Entgegenhaltungen:
- EP-A- 0 227 407
- EP-A- 0 785 625

## Beschreibung

Die Erfindung bezieht sich auf eine Halbleiterschaltungsanordnung zum Steuern einer hohen Spannung mit einer Serienschaltung von Halbleitermodulen, wobei die hohe Spannung gegebenenfalls zwischen den Enden der Serienschaltung abfällt.

Außerdem bezieht sich die Erfindung auf eine Halbleiterschaltungsanordnung zum Steuern eines Stroms großer Stromstärke mit einer Parallelschaltung von Halbleitermodulen, die jeweils Teilströme führen.

Die Erfindung findet Anwendung in technischen Gebieten, bei denen Leistungshalbleiter zur Steuerung hoher Spannungen, typischerweise mindestens mehrerer Tausend Volt oder hoher Ströme, typischerweise mindestens mehrere Hundert Ampere eingesetzt werden. Dies ist beispielsweise auf dem Gebiet der Energieversorgung der Fall.

Üblicherweise werden Schalter für hohe Spannungen als mechanische Schalter ausgebildet, bei denen zwei Kontakte durch Bewegung wenigstens eines Kontaktes unter Erzeugung eines Funkens beziehungsweise Lichtbogens voneinander getrennt werden. Dies erfordert die Konstruktion und den Bau eines Schalterantriebes sowie Kraftspeicher, Verklinkungen und Steuerungen für den Antrieb und lichtbogenresistente Schaltkontakte.

Der konstruktive Aufwand für derartige Schalter lässt sich grundsätzlich durch die Verwendung von Halbleiterelementen wesentlichen reduzieren.

Jedoch ist die Verwendung von Leistungshalbleitern in hohen Leistungsbereichen schwierig wegen der begrenzten Spannungs- und Stromfestigkeit.

Aus diesem Grunde werden Schalter zum Schalten hoher Spannungen aus elektrisch in Reihe geschalteten Bauelementen gebildet. Derartige Schalter werden beispielsweise für die Hochspannungsgleichstromübertragung verwendet, wo Wechselspannungen von einigen Hundert Kilo-Volt (KV) mit Halbleitern gleichgerichtet und am Ende einer langen Übertragungsstrecke wieder in Wechselspannung umgerichtet werden. Hierdurch wird einerseits durch die Verwendung einer hohen Spannung der ohmsche Leitungsverlust minimiert, andererseits durch die Gleichrichtung der dielektrische Verlust durch kapazitive und induktive Lasten klein gehalten.

Da bei derartigen Reihenschaltungen eine größere Anzahl von Halbleiter-Bauelementen verwendet wird, muss mit dem Ausfall einzelner Bauelemente während des Betriebes gerechnet werden. Es ist daher üblich, in einer derartigen Reihenschaltung mehr Bauelemente anzuordnen, als zur Erzielung der notwendigen Spannungsfestigkeit notwendig wäre. Die einzelnen Bauelemente werden so ausgeführt, dass sie bei einer Funktionsstörung sicher in einen dauerhaft leitenden Zustand übergehen und die Redundanz ist derart, dass die verbleibenden funktionierenden Halbleiter in der Summe die notwendige Spannungsfestigkeit aufweisen.

Bisher wurde diese Funktion eines Bauelementes, bei Ausfall oder Funktionsstörung in einen sicher leitenden Zustand überzugehen, durch die Verwendung von Druckkontaktbauformen in Scheibenzellenform (Presspack, Hockeypug) erreicht. Dies ist beispielsweise für Thyristoren und Dioden bekannt. Im Fall eines Durchbruchs des Silicium-Chips wird damit ein Kurzschluss zwischen den massiven Elektrodenplatten, die auf die beiden Seiten des Silicium-Chips aufgedrückt sind, erreicht. Der Kurzschluss entsteht durch das Aufschmelzen des jeweiligen Silicium-Chips.

Auch für IGBT's (IGBT = Insulated Gate Bipolar Transistor) ist die Bauform in Presspack-Gehäusen bekannt. Jedoch bedingen die MOS-Strukturen (MOS = Metal Oxide Semiconductor) auf der Chip-Oberseite von IGBT's technologische Nachteile. Die Herstellungsmethoden für IGBT's in Presspack-Gehäusen sind somit sehr aufwendig und teuer.

Es ist auch denkbar, zum Steuern von Strömen großer Stromstärke eine Parallelschaltung von Halbleitermodulen vorzusehen, die jeweils Teilströme führen. In diesem Fall führt ein Leitendwerden eines Halbleitermoduls durch eine Funktionsstörung dazu, dass die gesamte Parallelschaltung und somit die Halbleiterschaltungsanordnung für den Strom durchlässig wird. In diesem Fall kann somit nicht mit einem Bauelement in Form eines Presspacks gearbeitet werden, sondern es muss im Fall einer Funktionsstörung für die Isolation des Halbleitermoduls aus der Schaltungsanordnung oder zumindest aus dem Strompfad gesorgt werden.

Aus der EP 0 785 625 A2 ist eine Serienschaltung von Leistungshalbleitermodulen bekannt, von denen jedes eine Parallelschaltung aus drei IGBTs umfasst. Die IGBTs werden mittels einer Steuereinheit gemeinsam über einen Schmitt-Trigger angesteuert. Bei einer Störung der optischen Ansteuerung der Steuereinheit können die IGBTs eingeschaltet werden, bevor es aufgrund einer sich aufbauenden Überspannung zu einer Zerstörung der IGBTs kommt.

Die EP 0 227 407 A2 offenbart eine Parallelschaltung von Leistungshalbleitermodulen, von den jedes mehrere in Reihe geschaltete Thyristoren enthält. Jedem Thyristor ist eine Sicherung zugeordnet, zu der er in Reihe geschaltet ist. Parallel zu der jeder Reihenschaltung aus einem Thyristor und der ihm zugeordneten Sicherung ist ein nichtlinearer Widerstand geschaltet. Dadurch ist auch bei einer Unterbrechung einer solchen Sicherung - beispielsweise aufgrund eines Kurzschlusses des ihr zugeordneten Thyristors - noch ein Stromfluss über die anderen Thyristoren möglich.

Fällt in einem solchen Leistungshalbleitermodul einer der Thyristoren der Reihenschaltung aus, so dass der Stromfluss unterbrochen ist.

Vor dem beschriebenen Hintergrund liegt der vorliegenden Erfindung die Aufgabe zugrunde, bei einer Halbleiterschaltungsanordnung zum Steuern einer hohen Spannung beziehungsweise bei einer Halbleiterschaltungsanordnung zum Steuern eines Stroms großer Stromstärke der eingangs genannten Art dafür zu sorgen, dass ein Funktionieren der Schaltungsanordnung auch bei Funktionsstörung oder Ausfall einzelner Halbleitermodule gewährleistet ist.

Die Aufgabe wird gelöst durch eine Halbleiterschaltungsanordnung gemäss Patentanspruch 1 bzw. 2. Ausgestaltungen und Weiterbildungen des Erfindungsgedankens sind Gegenstand von Unteransprüchen.

Bei einer Halbleiterschaltungsanordnung zum Steuern einer hohen Spannung gemäss Patentanspruch 1 wird die Aufgabe dadurch gelöst, dass jedes Halbleitermodul eine Parallelschaltung von wenigstens zwei Bauelementen aufweist, von denen wenigstens ein erstes Bauelement im Normalbetrieb für die an ihm anliegende Teilspannung der hohen Spannung leitend oder sperrend sein kann, dass das oder die übrigen Bauelemente einer Parallelschaltung im Normalbetrieb zumindest dann sperren, wenn das erste Bauelement sperrt und dass jedes Halbleitermodul so eingerichtet ist, dass im Fall einer Funktionsstörung des ersten Bauelementes das oder die übrigen Bauelemente bleibend in einen leitenden Zustand übergehen.

Betrachtet man die Anforderung einer derartigen Serien- oder Reihenschaltung und die entsprechende Redundanzanforderung genauer, so ergibt sich, dass im Falle des Ausfalls oder der Funktionsstörung eines Halbleitermoduls in der Serienschaltung an dieses nicht die Anforderung zu stellen ist, dass es jeden beliebigen Strom im dann vorhandenen geforderten Kurzschluss führen muss. Vielmehr muss es bis zur Grenze des in der Anwendung vorkommenden Stromes normale Durchlasseigenschaften zeigen, so lange die übrigen Halbleitermodule derselben Reihenschaltung funktionieren. Diese Durchlasseigenschaft muss nicht notwendigerweise mit einem Durchschmelzen des Silizium-Chips und entsprechenden Durchkontaktieren eines Presspacks erreicht werden.

Es kann vielmehr erfindungsgemäß einfacher vorgesehen sein, dass bei Ausfall eines Bauelementes eines Halbleitermoduls egal ob dies in einen leitenden, teilweise leitenden oder sperrenden Zustand übergegangen ist, ein zu diesem parallel geschaltetes weiteres Bauelement des Halbleitermoduls eingeschaltet wird, so dass es die an der Parallelschaltung anliegende Spannung nicht sperrt, sondern leitend wird. Damit ist der möglicherweise undefinierte Zustand des ersten Bauelementes nicht mehr wichtig. Die Parallelschaltung ist damit in einen leitenden Zustand versetzt, so dass an dieser nur die Einschaltspannung auftritt. Die übrigen Halbleitermodule übernehmen die Steuerung der hohen Spannung dann allein. Je nach dem Maß der Redundanz bei der erfindungsgemäßen Halbleiterschaltungsanordnung kann auch der Ausfall mehrerer Halbleitermodule durch die übrigen Halbleitermodule ausgeglichen werden. Es muss lediglich die Bedingung erfüllt sein, dass die noch funktionierenden Halbleitermodule in Summe eine Spannungsfestigkeit aufweisen, die der anliegenden hohen Spannung entspricht.

Bei einer Halbleiterschaltungsanordnung zum Steuern eines Stroms großer Stromstärke nach Anspruch 2 wird die Aufgabe erfindungsgemäß dadurch gelöst, dass jedes Halbleitermodul eine Serienschaltung von wenigstens zwei Bauelementen aufweist, von denen wenigstens ein erstes Bauelement im Normalbetrieb für die an ihm anliegende Spannung leitend oder sperrend sein kann, dass das oder die übrigen Bauelemente der jeweiligen Serienschaltung im Normalbetrieb zumindest dann leiten, wenn das erste Bauelement leitet und dass jedes Halbleitermodul so eingerichtet ist, dass im Fall einer Funktionsstörung des ersten Bauelementes das oder die übrigen Bauelemente bleibend in einen sperrenden Zustand übergehen.

Fällt in einer aus dem Stand der Technik bekannten Parallelschaltung von Halbleitermodulen eines dadurch aus, dass es in einen dauerhaft leitenden Zustand übergeht, so ist die gesamte Parallelschaltung leitend überbrückt und nicht mehr zu dem vorgesehenen Zweck der Steuerung eines Stromes einsetzbar.

Dadurch, dass jedes einzelne Halbleitermodul eine Serienschaltung von Bauelementen aufweist, kann bei Funktionsstörung oder Ausfall eines dieser Bauelemente ein anderes Bauelement der Serienschaltung in einen sperrenden Zustand versetzt werden, so dass die ganze Serienschaltung und somit das entsprechende Halbleitermodul in einen sperrenden Zustand überführt ist. In diesem Zustand hängt die Funktion der Schaltungsanordnung beim Steuern eines Stroms großer Stromstärke nur noch von den übrigen parallel geschalteten Halbleitermodulen ab. Ist bei diesen eine entsprechende Redundanz vorgesehen, so können diese den zu steuernden Strom weiterhin durchlassen oder sperren. Die Halbleiterschaltungsanordnung kann somit trotz Ausfall eines Halbleitermoduls sicher weiterverwendet werden, da das ausgefallene Halbleitermodul sicher in einen sperrenden Zustand versetzt werden kann.

Eine vorteilhafte Ausgestaltung der Erfindung sieht vor, dass wenigstens für das erste Bauelement ein Spannungssensor zur Messung der abfallenden Spannung vorgesehen ist.

Besteht die Halbleiterschaltungsanordnung aus einer Serienschaltung von Halbleitermodulen zum Steuern einer hohen Spannung, und jedes einzelne Halbleitermodul aus einer Parallelschaltung von Bauelementen, so ist es sinnvoll, die Sperrspannung an wenigstens einem der Bauelemente oder auch an allen Bauelementen mittels eines Sensors zu messen und das Messergebnis in einer Steuereinrichtung zu verarbeiten. Ergibt sich durch die Spannungsmessung eine Funktionsstörung eines Bauelementes eines Halbleitermoduls, so wird ein weiteres Bauelement desselben Halbleitermoduls durch die Steuereinrichtung in einen leitenden Zustand versetzt. Dies ist besonders einfach, wenn es sich bei den Bauteilen um Thyristoren oder IGBT's handelt, bei denen lediglich ein Steuereingang entsprechend durch die Steuereinrichtung angesteuert werden muss.

Bei einer Halbleiterschaltungsanordnung zum Steuern eines Stroms großer Stromstärke mit mehreren parallel geschalteten Halbleitermodulen, von denen jedes eine Serienschaltung aufweist, kann beispielsweise vorgesehen sein, dass im Normalbetrieb die übrigen Bauelemente im eingeschalteten Zustand sind und der Teilstrom lediglich durch Ein- und Ausschalten des ersten Bauelementes gesteuert wird. In diesem Fall wird bei einer detektierten Funktionsstörung des ersten Bauteils wenigstens eines der übrigen Bauteile in einen sperrenden, das heißt nicht leitenden, Zustand versetzt, um das gesamte Halbleitermodul in einen sperrenden, das heißt nicht leitenden, Zustand zu bringen. Dies kann ebenfalls besonders einfach dann geschehen, wenn die Bauelemente durch Thyristoren oder IGBT's gebildet sind, indem durch eine Steuereinrichtung wenigstens eins der übrigen Bauelemente derart angesteuert wird, dass es in einen sperrenden Zustand übergeht.

Die Funktionsstörung wird somit mittels eines Spannungssensors detektiert und wenigstens ein Bauelement geeignet angesteuert, um das funktionsgestörte Halbleitermodul entweder in einen definierten leitenden Zustand oder in einen definierten sperrenden Zustand zu versetzen.

Eine weitere vorteilhafte Ausgestaltung der Erfindung sieht vor, dass wenigstens für das erste Bauelement ein Stromsensor zum Messen des durchfließenden Stromes vorgesehen ist.

So kann die Steuereinrichtung auch aufgrund einer Strommessung das ordnungsgemäße Funktionieren eines Bauelementes detektieren und entsprechend einwirken.

Eine weitere vorteilhafte Ausgestaltung der Erfindung sieht vor, dass wenigstens für das erste Bauelement ein Sensor zur Überwachung eines Steuereinganges vorgesehen ist.

Eine Funktionsstörung eines der genannten Halbleiterbauelemente kann beispielsweise darin bestehen, dass ein Kurzschluss zwischen dem Steuereingang und einem Emitteranschluss entsteht, so dass anders als im Normalzustand ein hoher Steuerstrom (Gatestrom) fließt. Dies ist einerseits für die Steuereinrichtung schädlich, die den hohen Steuerstrom liefern muss, für den sie normalerweise nicht ausgelegt ist. Andererseits ist die Funktion des jeweiligen Halbleitermoduls gestört. In jedem Fall sollte der Sensor zur Überwachung eines Steuereinganges ein Störungssignal an die Steuereinrichtung abgeben, um die Überführung des Halbleitermoduls in einen definiert leitenden oder in einen definiert sperrenden Zustand zu bewirken.

Es kann auch vorteilhaft vorgesehen sein, dass die Zuleitung eines Steuereinganges eine Sicherung und/ oder einen Strombegrenzer aufweist. Besonders einfach ist die Erfindung dadurch realisierbar, dass eine Sicherung durch einen bei Überlast aufschmelzenden Bonddraht als Zuleitung des Steuereinganges gebildet ist.

Eine besonders vorteilhafte Realisierung der Erfindung ergibt sich dadurch, dass wenigstens zwei aus der Gruppe der drei Sensoren: Spannungssensor, Stromsensor, Sensor zur Überwachung eines Steuereinganges, vorgesehen sind und dass die Steuereinrichtung die Signale dieser Sensoren verarbeitet, um Funktionsstörungen zu ermitteln. Insbesondere aus einer Verknüpfung der Signale der unterschiedlichen Sensoren kann die Steuereinrichtung mit großer Sicherheit das Vorliegen einer Funktionsstörung ermitteln und eine entsprechende Ansteuerung der Halbleiterschaltungsanordnung bewirken.

Die Erfindung bezieht sich außerdem auf eine Halbleiterschaltungsanordnung, bei der mittels wenigstens eines Sensors in jedem Halbleitermodul durch die Steuereinrichtung die störungsfreie Funktion geprüft und im Falle einer Funktionsstörung eines Bauelementes wenigstens ein anderes Bauelement desselben Halbleitermoduls derart angesteuert wird, dass das Halbleitermodul insgesamt entweder in einen definiert leitenden oder einen definiert sperrenden Zustand überführt wird.

Die Erfindung wird nachfolgend anhand der in den Figuren der Zeichnung dargestellten Ausführungsbeispiele näher erläutert. Es zeigt:
- Figur 1a: eine Halbleiterschaltungsanordnung zum Steuern einer hohen Spannung mit einer Serienschaltung von Halbleitermodulen,
- Figur 1b: ein einziges der Halbleitermodule aus der Figur 1a in detaillierter Ansicht,
- Figur 2a: eine Halbleiterschaltungsanordnung zum Steuern eines Stroms großer Stromstärke mit einer Parallelschaltung von Halbleitermodulen und
- Figur 2b: ein einzelnes der Halbleitermodule aus der Figur 2a in einer Detailansicht und
- Figur 3: eine Darstellung von mehreren in einem einzigen Modulgehäuse zu einem Halbleitermodul zusammengefassten Bauelementen.

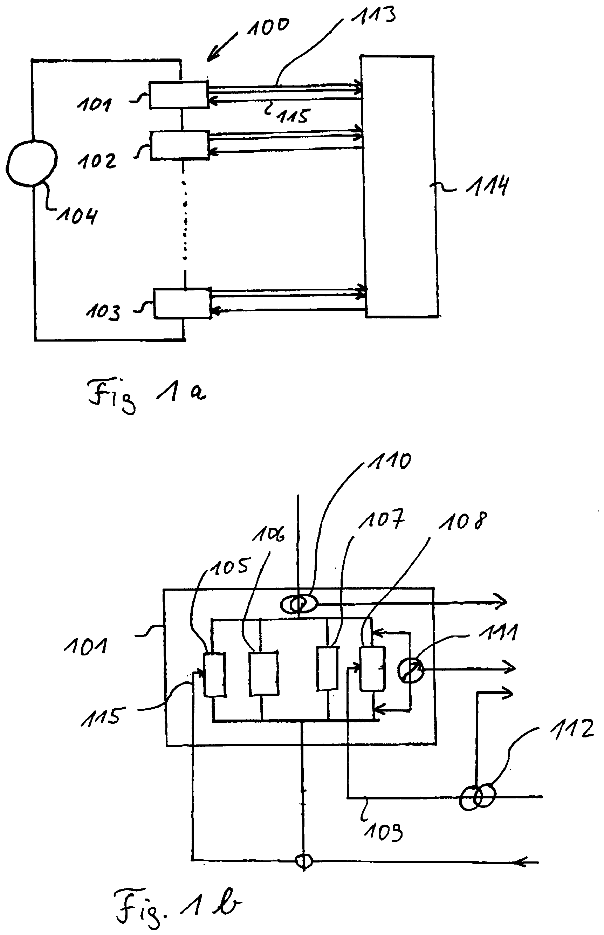

Die Halbleiterschaltungsanordnung 100 gemäß Figur 1a zeigt eine Serienschaltung von Halbleitermodulen 101, 102, 103 an der eine hohe Spannung anliegt, die durch die Spannungsquelle 104 symbolisiert ist. Jeweils Teilspannungen der Spannung 104 liegen an jedem der Halbleitermodule 101, 102, 103 an.

Wie die Figur 1b zeigt, besteht jedes der Halbleitermodule 101, 102, 103, von denen beispielhaft nur eines 101 dargestellt ist, unter anderem aus einer Parallelschaltung von Bauelementen 105, 106, 107, 108, von denen jedes einzelne die an dem Halbleitermodul 101 anliegende Spannung sperren oder leiten kann. Jedes der Bauelemente weist einen Steuereingang auf, der nur beispielhaft bei den Bauelementen 105, 108 durch die Zuleitung 109, 115 dargestellt ist und der durch eine Steuereinrichtung angesteuert wird. Im Normalbetrieb können beispielsweise die Bauelemente 105, 106, 107 dauerhaft sperrend und das erste Bauelement 108 je nach den Bedürfnissen der Halbleiterschaltungsanordnung entsprechend wechselnd leitend oder sperrend angesteuert sein. Somit bestimmt die Ansteuerung des Bauelementes 108, ob das Halbleitermodul 101 leitend oder sperrend ist. Die übrigen Halbleitermodule sind entsprechend gebaut und synchron angesteuert.

Die Funktion des Halbleitermoduls wird mittels eines Stromsensors 110 sowie eines Spannungssensors 111 und eines Sensors 112 in der Zuleitung 109 des Steuereingangs des ersten Bauelementes 108 überwacht. Eine oder mehrere Messgrößen des Stromsensors 110 des Spannungssensors 111 oder des Sensors 112 des Steuereingangs werden, wie in Figur 1a schematisch durch die Pfeile 113 dargestellt, einer Steuereinrichtung 114 zugeleitet.

Die Steuereinrichtung 114 überprüft, ob jede erfasste der drei überwachten Größen einer störungsfreien Funktion des entsprechenden Halbleitermoduls 101 beziehungsweise des variabel angesteuerten ersten Bauelementes 108 entspricht.

Ist dies nicht der Fall, so bewirkt die Steuereinrichtung 114 eine Ansteuerung der übrigen Bauelemente 105, 106, 107 mittels der Steuereingänge, von denen einer, 115 beispielhaft dargestellt ist derart, dass die übrigen Bauelemente dauerhaft in einen leitenden Zustand übergehen, so dass das gesamte Halbleitermodul 101 in einen leitenden Zustand übergeht. Von diesem Zeitpunkt an übernehmen die übrigen Halbleitermodule 102, 103 und weitere, nicht dargestellte Halbleitermodule gemäß Figur 1a allein die Steuerung der hohen Spannung 104.

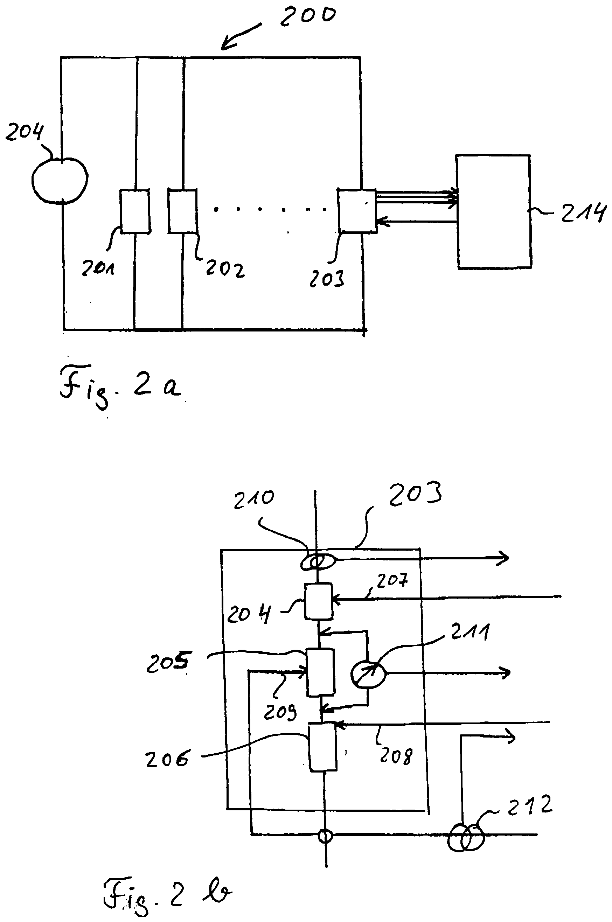

Mittels der in der Figur 2a dargestellten Halbleiterschaltungsanordnung mit einer Parallelschaltung 200 von Halbleitermodulen 201, 202, 203 soll ein Strom mit großer Stromstärke gesteuert werden, der durch die Stromquelle 204 symbolisch dargestellt ist.

Jedes der Halbleitermodule 201, 202, 203 übernimmt aufgrund der Parallelschaltung einen Teilstrom.

Jedes der Halbleitermodule 201, 202, 203 weist, wie in der Figur 2b detailliert dargestellt, in seinem Inneren eine Serienschaltung aus mehreren Bauelementen 204, 205, 206 auf.

Typischerweise sind die Bauelemente 204, 206 mittels Steuereingängen 207, 208 dauerhaft in den leitenden Zustand versetzt. Das Bauelement 205 wird mittels des Steuereingangs 209 jeweils zeitlich so gesteuert, wie es die Halbleiterschaltungsanordnung erfordert. Vom jeweiligen Zustand des Bauelements 205 hängt somit ab, ob das Halbleitermodul 203 insgesamt leitend oder sperrend ist.

Mittels des Stromsensors 210, des Spannungssensors 211 und des Sensors 212 für den Steuereingang 209 oder auch nur eines dieser Sensoren wird die Funktion des Bauelements 205 durch die Steuereinrichtung 214 laufend überwacht.

Stimmt die erfasste Spannung, der Strom oder der in dem Steuereingang 209 erfasste Strom nicht mit den Sollwerten überein, so wird eine Funktionsstörung des Bauelementes 205 detektiert und durch eine Ansteuerung der Steuereingänge 207 und/oder 208 der Bauelemente 204, 206 versetzt die Steuereinrichtung 214 die entsprechenden Bauelemente in einen nicht leitenden Zustand, so dass das Halbleitermodul 203 insgesamt in einen nicht leitenden Zustand überführt wird.

In diesem Zustand übernehmen die übrigen Halbleitermodule 201, 202 und weitere in der Figur 2a nicht dargestellte die Steuerung des Stroms allein. Auf diese Weise bleibt die Halbleiterschaltungsanordnung trotz des Ausfalls eines Halbleitermoduls funktionsfähig.

In der Steuereinrichtung 214 befindet sich ebenso wie in der Steuereinrichtung 114, eine Auswertelogik, die beispielsweise die von den verschiedenen Sensoren erfassten Werte miteinander verknüpft oder mit Referenzwerten vergleicht, um eine sichere Aussage über die Funktion des jeweils überwachten Bauelementes zu erhalten.

Da im Normalfall bei jedem einzelnen Halbleitermodul die entstehende Wärme etwa zur Hälfte aus Durchlassverlusten und zur Hälfte aus Schaltverlusten besteht, sinkt bei den abgeschalteten Halbleitermodulen der Gesamtwärmeanfall, da keine Schaltverluste mehr anfallen. Bei den übrigen Halbleitermodulen treten entsprechend höhere Verluste auf, die jedoch durch eine redundante Auslegung aufgefangen werden können.

Somit können auch gegebenenfalls mehrere gestörte Halbleitermodule durch die Steuereinrichtung 114, 214 stillgesetzt werden, ohne dass die gesamte Halbleiterschaltungsanordnung funktionsuntüchtig wird.

Im einfachsten Fall ist die Steuereinrichtung 114, 214 extrem einfach gestaltet und es wird im Falle einer Fehlfunktion lediglich ein einfaches Flip-Flop an den Steuereingängen der verschiedenen Bauelemente eines gestörten Halbleitermoduls derart gesetzt, dass das Halbleitermodul in einen definierten leitenden oder nicht leitenden Zustand gebracht wird. Es empfiehlt sich, den hohen Anforderungen an die Funktionssicherheit dadurch nachzukommen, dass auch die Steuereinrichtungen redundant ausgeführt werden, dass also beispielsweise zwei Steuereinrichtungen parallel zueinander betrieben werden.

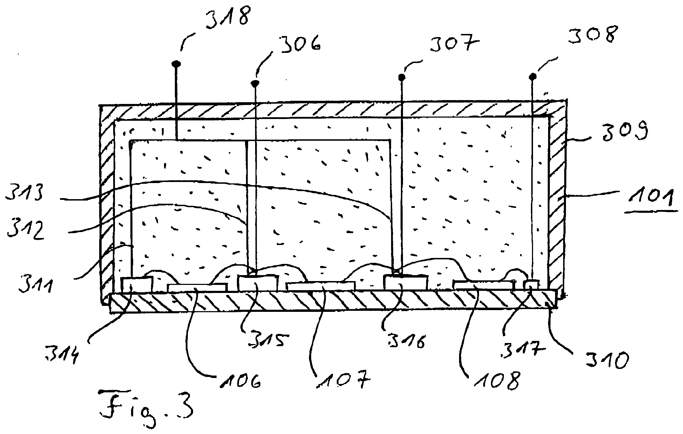

Die Figur 3 zeigt ein Halbleitermodul 101 in einer integrierten Bauform mit drei Halbleiterbauelementen 106, 107, 108, die als Silizium- Chips ohne gesonderte Gehäuse ausgeführt sind. Die drei Halbleiterbauelemente, beispielsweise IGBT's sind elektrisch parallelgeschaltet. Die drei Gateleitungen 306, 307, 308 sind gesondert durch das Modulgehäuse 309 nach außen geführt, so dass jedes Bauelement einzeln angesteuert werden kann. Es kann auch vorgesehen sein, Gruppen von Bauelementen zusammenzufassen und jeweils gemeinsam anzusteuern, beispielsweise sechs Gruppen zu jeweils 4 Bauelementen, deren Gateleitungen dann gemeinsam nach außen geführt sind. Die Gruppen sind dann einzeln steuerbar.

Die Chips können einzeln auf einen Träger gelötet werden, der gleichzeitig die thermische Ankopplung zur Kühlung bildet und als gemeinsamer Kollektor 310 dient. Die Emitteranschlüsse 311, 312, 313 werden vorteilhaft zu einem gemeinsamen Anschluss 318 zusammengeführt. Zur elektrischen Isolation der einzelnen Bauelemente ist das Innere des Modulgehäuses 309 möglichst blasenfrei mit einem Silikongel vergossen.

Die Gate- und Emitterleitungen im Modul werden entweder auf leitend beschichteten Keramiksubstraten oder auf Leiterplatten 314, 315, 316, 317 gesammelt und vom Boden/Träger 310 isoliert. Diese Keramiksubstrate oder Leiterplatten 314, 315, 316, 317 bilden außerdem die Träger für entsprechende Verdrahtungen und gruppenweise Verbindungen der Emitter- und Gateanschlüsse und tragen gegebenenfalls Bonddrähte zur Kontaktierung der Chips/Halbleiterbauelemente. Auch die nach außen geführten Anschlüsse sind dort kontaktiert.

Der Träger 310 ist, da er einen ähnlichen Wärmeausdehnungskoeffizient wie die Silizium - Chips 106, 107, 108 aufweisen muss, beispielsweise aus Mo, AlSiC oder CuSiC mit lötbarer Beschichtung hergestellt.

## Patentansprüche

1. Halbleiterschaltungsanordnung zum Steuern einer hohen, zwischen den Enden einer Serienschaltung von Halbleitermodulen (101, 102, 103) abfallenden Spannung (104), wobei
jedes Halbleitermodul (101, 102, 103) eine Parallelschaltung von wenigstens zwei mittels einer Steuereinrichtung (114) jeweils über einen Steuereingang ansteuerbaren Bauelementen (105, 106, 107, 108) aufweist, von denen wenigstens ein erstes Bauelement (108) im Normalbetrieb für die an ihm anliegende Teilspannung der hohen Spannung leitend oder sperrend sein kann,
das oder die übrigen Bauelemente (105, 106, 107) einer Parallelschaltung im Normalbetrieb zumindest dann sperren, wenn das erste Bauelement (108) sperrt, und
wobei die Steuereinrichtung (114) dazu ausgebildet ist, nach einer festgestellten Funktionsstörung des ersten Bauelementes (108) eines Halbleitermoduls (101, 102, 103) das oder die übrigen Bauelemente (105, 106, 107) des betreffenden Halbleitermoduls (101, 102, 103) mittels deren Steuereingängen so anzusteuern, dass das oder die übrigen Bauelemente (105, 106, 107) des betreffenden Halbleitermoduls (101, 102, 103) bleibend in einen leitenden Zustand übergehen, so dass das gesamte das erste Bauelement (108) aufweisende Halbleitermodul (101) in einen dauerhaft leitenden Zustand übergeht.

2. Halbleiterschaltungsanordnung zum Steuern eines Stroms großer Stromstärke mit einer Parallelschaltung von Halbleitermodulen (201, 202, 203), die jeweils Teilströme führen, wobei
jedes Halbleitermodul (201, 202, 203) eine Serienschaltung von wenigstens zwei mittels einer Steuereinrichtung (214) jeweils über einen Steuereingang ansteuerbaren Bauelementen (204, 205, 206) aufweist, von denen wenigstens ein erstes Bauelement (205) im Normalbetrieb für die an ihm anliegende Spannung in einen leitenden oder in einen sperrenden Zustand versetzt werden kann,
das oder die übrigen Bauelemente (204, 206) der jeweiligen Serienschaltung im Normalbetrieb zumindest dann leiten, wenn das erste Bauelement (205) leitet, und
wobei die Steuereinrichtung dazu ausgebildet ist, nach einer festgestellten Funktionsstörung des ersten Bauelementes (205) das oder die übrigen Bauelemente (204, 206) des betreffenden Halbleitermoduls (203) durch eine Ansteuerung von deren Steuereingängen (207, 208) so anzusteuern, dass das oder die übrigen Bauelemente (204, 206) des betreffenden Halbleitermoduls (203) bleibend in einen sperrenden Zustand übergehen und das Halbleitermodul (203) insgesamt in einen nicht leitenden Zustand überführt wird.

3. Halbleiterschaltungsanordnung nach Anspruch 1 oder 2, **dadurch gekennzeichnet, dass** wenigstens für das erste Bauelement (108, 205)ein Spannungssensor (111, 211) zur Messung der abfallenden Spannung vorgesehen ist.

4. Halbleiterschaltungsanordnung nach Anspruch 1,2 oder 3, **dadurch gekennzeichnet, dass** wenigstens für das erste Bauelement (108, 205) ein Stromsensor (110, 210) zum Messen des durchfließenden Stromes vorgesehen ist.

5. Halbleiterschaltungsanordnung nach Anspruch 1,2,3 oder 4, **dadurch gekennzeichnet, dass** wenigstens für das erste Bauelement ein Sensor (112, 212) zur Überwachung eines Steuereinganges vorgesehen ist.

6. Halbleiterschaltungsanordnung nach einem der Ansprüche 1 bis 5, **dadurch gekennzeichnet, dass** die Zuleitung eines Steuereinganges (109,209) eine Sicherung und/ oder einen Strombegrenzer aufweist.

7. Halbleiterschaltungsanordnung nach Anspruch 6, **dadurch gekennzeichnet, dass** ein Strombegrenzer durch einen bei Überlast aufschmelzenden Bonddraht als Zuleitung des Steuereinganges gebildet ist.

8. Halbleiterschaltungsanordnung nach Anspruch 1 bis 7, **dadurch gekennzeichnet, dass** die Bauelemente als Thyristoren ausgebildet sind.

9. Halbleiterschaltungsanordnung nach einem der Ansprüche 1 bis 5, **dadurch gekennzeichnet, dass** die Bauelemente als IGBT's ausgebildet sind.

10. Halbleiterschaltungsanordnung nach einem der Ansprüche 1 bis 9, **dadurch gekennzeichnet, dass** wenigstens zwei aus der Gruppe der Sensoren: Spannungssensor, Stromsensor, Sensor zur Überwachung eines Steuereinganges, vorgesehen sind und dass die Steuereinrichtung die Signale der Sensoren verarbeitet, um einen Störungszustand zu detektieren.

11. Halbleiterschaltungsanordnung nach einem der Ansprüche 1 bis 10, **dadurch gekennzeichnet, dass** wenigstens ein Sensor (111, 211, 110, 210, 112, 212) in jedem Halbleitermodul (101, 102, 103, 201, 202, 203) vorgesehen ist mittels dessen die Steuereinrichtung die störungsfreie Funktion prüft und im Falle einer Funktionsstörung eines Bauelementes (108, 205) wenigstens ein anderes Bauelement desselben Halbleitermoduls derart ansteuert, dass das Halbleitermodul (101, 102, 103, 201, 202, 203) insgesamt entweder in einen definiert leitenden oder einen definiert sperrenden Zustand überführt wird.

## Claims

1. Semiconductor circuit arrangement for controlling a high voltage (104) falling between the ends of a series connection of semiconductor modules (101, 102, 103), wherein
each semiconductor module (101, 102, 103) has a parallel connection of at least two components (105, 106, 107, 108), which can each be controlled via a control input by means of a control device (114), and of which at least a first component (108) can be conductive or blocking in normal operation for the partial voltage of the high voltage applied to it,
the remaining component or components (105, 106, 107) of a parallel connection are blocking in normal operation at least when the first component (108) is blocking, and
wherein the control device (114) is designed to control, after a detected malfunction of the first component (108) of a semiconductor module (101, 102, 103), the remaining component or components (105, 106, 107) of the corresponding semiconductor module (101, 102, 103) via their control inputs in such a way that the remaining component or components (105, 106, 107) of the corresponding semiconductor module (101, 102, 103) steadily pass into a conductive state, so that the whole semiconductor module (101) comprising the first component (108) passes into a long-lasting conductive state.

2. Semiconductor circuit arrangement for controlling a current of high amperage with a parallel connection of semiconductor modules (201, 202, 203), which respectively carry partial currents, wherein
each semiconductor module (201, 202, 203) has a series connection of at least two components (204, 205, 206), which can each be controlled via a control input by means of a control device (214), and of which at least a first component (205) can be put in normal operation into a conductive or into a blocking state for the partial voltage of the high voltage applied to it,
the remaining component or components (204, 206) of the corresponding series connection are conductive in normal operation at least when the first component (205) is conductive, and
wherein the control device (214) is designed to control, after a detected malfunction of the first component (205) of a semiconductor module (101, 102, 103), the remaining component or components (204, 206) of the corresponding semiconductor module (203) via a control of their control inputs (207, 208) in such a way that the remaining component or components (204, 206) of the corresponding semiconductor module (203) steadily pass into a blocking state and the semiconductor module (203) on the whole is put into non-conductive state.

3. Semiconductor circuit arrangement according to claims 1 or 2, **characterized in that** it is provided a voltage sensor (111, 211) for measuring the falling voltage at least for the first component (108, 205).

4. Semiconductor circuit arrangement according to one of the claims 1 2, or 3, **characterized in that** it is provided a current sensor (110, 210) for measuring the flowing current at least for the first component (108, 205).

5. Semiconductor circuit arrangement according to one of the claims 1 2, 3, or 4, **characterized in that** it is provided a sensor (112, 212) for monitoring a control input at least for the first component (108, 205).

6. Semiconductor circuit arrangement according to one of the claims 1 to 5, **characterized in that** the supply line of a control input (109, 209) has a fuse and/or a current limiter.

7. Semiconductor circuit arrangement according to claim 6, **characterized in that** the current limiter is formed as a supply line of the control input by a bond wire fusing in the event of an overload.

8. Semiconductor circuit arrangement according to one the claims 1 to 7, **characterized in that** the components are embodied as thyristors.

9. Semiconductor circuit arrangement according to one the claims 1 to 5, **characterized in that** the components are embodied as IGBTs.

10. Semiconductor circuit arrangement according to one the claims 1 to 9, **characterized in that** at least two sensors from the group of sensors: voltage sensor, current sensor, sensor for monitoring a control input, are included and that the control device processes the signals of the sensors in order to detect a malfunction state.

11. Semiconductor circuit arrangement according to one the claims 1 to 10, **characterized in that** at least one sensor (111, 211, 110, 210, 112, 212) is provided in each semiconductor module (101, 102, 103, 201, 202, 203), via which the control device checks if the functioning is trouble-free and in the event of a malfunction of a component (108, 205) controls at least one other component of the same semiconductor module in such a way that the semiconductor module (101, 102, 103, 201, 202, 203) on the whole is put either in a selected conductive or in a selected blocking state.

## Revendications

1. Dispositif de circuit à semi-conducteur pour commander une haute tension (104) chutant entre les extrémités d'un circuit série de modules semi-conducteurs (101, 102, 103),
chaque module semi-conducteur (101, 102, 103) comprenant un circuit parallèle d'au moins deux composants (105, 106, 107, 108) qui sont chacun contrôlables par une entrée de commande par le biais d'un dispositif de commande (114) et desquels au moins un premier composant (108) peut être en fonctionnement normal conducteur ou bloquant pour la tension partielle de la haute tension appliquée à ses bornes,
le ou les composants restants (105, 106, 107) du circuit parallèle étant bloquants en fonctionnement normal au moins quand le premier composant (108) est bloquant, et
le dispositif de commande (114) étant conçu pour contrôler, après un dysfonctionnement détecté du premier composant (108) d'un module semi-conducteur (101, 102, 103), le ou les composants restants (105, 106, 107) du module semi-conducteur en cause (101, 102, 103) par leurs entrées de commande de telle sorte que le ou les composants restants (105, 106, 107) du module semi-conducteur en cause (101, 102, 103) passent de manière durable dans un état conducteur, si bien que tout le module semi-conducteur (101) comprenant le premier composant (108) passe dans un état conducteur durable.

2. Dispositif de circuit à semi-conducteur pour commander un courant de grande intensité avec un circuit parallèle de modules semi-conducteurs (201, 202, 203) qui transportent chacun des courants partiels,
chaque module semi-conducteur (201, 202, 203) comprenant un circuit série d'au moins deux composants (204, 205, 206) qui sont chacun contrôlables par une entrée de commande par le biais d'un dispositif de commande (214) et desquels au moins un premier composant (205) peut être mis en fonctionnement normal dans un état conducteur ou bloquant pour la tension appliquée à ses bornes,
le ou les composants restants (204, 206) du circuit série correspondant étant conducteurs en fonctionnement normal au moins quand le premier composant (205) est conducteur, et
le dispositif de commande (214) étant conçu pour contrôler, après un dysfonctionnement détecté du premier composant (205), le ou les composants restants (204, 206) du module semi-conducteur en cause (203) par un contrôle de leurs entrées de commande (207, 208) de telle sorte que le ou les composants restants (204, 206) du module semi-conducteur en cause (203) passent de manière durable dans un état bloquant et le module semi-conducteur (203) tout entier passe dans un état non-conducteur durable.

3. Dispositif de circuit à semi-conducteur selon la revendication 1 ou 2, **caractérisé en ce qu'**un capteur de tension (111, 211) pour mesurer la chute de tension est prévu au moins pour le premier composant (108, 205).

4. Dispositif de circuit à semi-conducteur selon la revendication 1, 2 ou 3, **caractérisé en ce qu'**un capteur de courant (110, 210) pour mesurer le courant qui passe est prévu au moins pour le premier composant (108, 205).

5. Dispositif de circuit à semi-conducteur selon la revendication 1, 2, 3 ou 4, **caractérisé en ce qu'**un capteur (112, 212) pour surveiller une entrée de commande est prévu au moins pour le premier composant (108, 205).

6. Dispositif de circuit à semi-conducteur selon l'une des revendications 1 à 5, **caractérisé en ce que** l'alimentation d'une entrée de commande (109, 209) comprend un fusible et/ou un limiteur de courant.

7. Dispositif de circuit à semi-conducteur selon la revendication 6, **caractérisé en ce qu'**un limiteur de courant est formé comme alimentation de l'entrée de commande par un fil de jonction qui fond en cas de surcharge.

8. Dispositif de circuit à semi-conducteur selon l'une des revendications 1 à 7, **caractérisé en ce que** les composants sont des thyristors.

9. Dispositif de circuit à semi-conducteur selon l'une des revendications 1 à 5, **caractérisé en ce que** les composants sont des IGBT.

10. Dispositif de circuit à semi-conducteur selon l'une des revendications 1 à 9, **caractérisé en ce qu'**au moins deux capteurs parmi le groupe de capteurs : capteurs de tension, capteur de courant, capteur pour surveiller une entrée de commande, sont prévus et que le dispositif de commande traite les signaux des capteurs afin de détecter un état dysfonctionnel.

11. Dispositif de circuit à semi-conducteur selon l'une des revendications 1 à 10, **caractérisé en ce qu**'au moins un capteur (111, 211, 110, 210, 112, 212) est prévu dans chaque module semi-conducteur (101, 102, 103, 201, 202, 203) par le moyen duquel le dispositif de commande vérifie que le fonctionnement se fait sans perturbations et, en cas de dysfonctionnement d'un composant (108, 205), contrôle au moins un autre composant du même module semi-conducteur, de telle façon que le module semi-conducteur (101, 102, 103, 201, 202, 203) tout entier passe soit dans un état conducteur défini, soit dans un état bloquant défini.
